Europäisches Patentamt

European Patent Office

Office européen des brevets

(11) Publication number: **0 183 849 B1**

# EUROPEAN PATENT SPECIFICATION
## published in accordance with Art. 158(3) EPC

(45) Date of publication of patent specification: **03.04.91**   (51) Int. Cl.5: **H03F 3/217, H03K 7/08**

(21) Application number: **85901552.1**

(22) Date of filing: **11.03.85**

(86) International application number:
**PCT/JP85/00119**

(87) International publication number:
**WO 85/04293 (26.09.85 85/21)**

(54) **CONTROL CIRCUIT THAT OPERATES ON PULSE-WIDTH MODULATED SIGNALS.**

(30) Priority: **12.03.84 JP 46710/84**

(43) Date of publication of application:
**11.06.86 Bulletin 86/24**

(45) Publication of the grant of the patent:
**03.04.91 Bulletin 91/14**

(84) Designated Contracting States:
**AT BE CH DE FR GB LI NL SE**

(56) References cited:
**DE-A- 3 236 692**
**JP-B- 5 627 001**
**JP-Y- 432 802**
**US-A- 3 958 171**

(73) Proprietor: **SONY CORPORATION**
**7-35 Kitashinagawa 6-Chome Shinagawa-ku Tokyo 141(JP)**

(72) Inventor: **WACHI, Shigeaki Sony Corporation**
**7-35, Kitashinagawa 6-chome**
**Shinagawa-ku Tokyo 141(JP)**
Inventor: **ITO, Akashi Sony Corporation**
**7-35, Kitashinagawa 6-chome**
**Shinagawa-ku Tokyo 141(JP)**
Inventor: **YOSHII, Fumihiko Sony Corporation**
**7-35, Kitashinagawa 6-chome**
**Shinagawa-ku Tokyo 141(JP)**

(74) Representative: **Thomas, Christopher Hugo et al**
**D Young & Co 10 Staple Inn**
**London WC1V 7RD(GB)**

## Description

This invention relates to control circuits operating with pulse-width modulated (PWM) signals.

There has been proposed a signal reproducing system for reproducing information signals such as video signals and audio signals from a disc-shaped recording medium having record tracks, in which the information signals are recorded in a line of pits. In this system, the record tracks are scanned by a light beam, and variations in the reflected light beam are detected to reproduce the recorded information signals. Such a system is known as a video disc system, a digital audio disc system or the like. A reproducing apparatus for such a system is required to have automatic control operations for respectively maintaining the light beam, which is directed onto the recording medium to scan the record tracks thereon, in correct tracking relation to each record track, and for focusing the light beam properly on the record tracks. These automatic control operations are called tracking control and focusing control, respectively, and are usually carried out by driving an optical device, such as a lens or a mirror, forming part of an optical head, for causing the light beam to be directed onto the record medium to control the position thereof, with control signals which are respectively obtained in response to the tracking condition and the focusing condition of the light beam.

To drive the optical device for tracking control or focusing control, the reproducing apparatus is provided with a driving circuit which is operative to supply a driving current or voltage to an actuating device provided for the optical device in accordance with the control signal. For driving the optical device in this way, it had been proposed to employ a control circuit operating with a PWM signal.

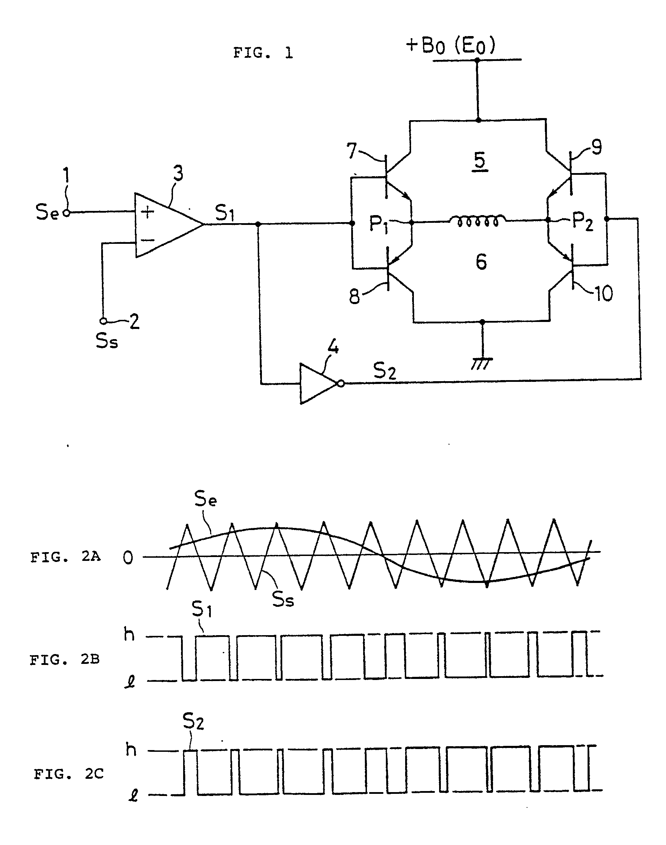

Such a control circuit is shown in Figure 1. In this circuit an analogue control signal Se as shown in Figure 2A, for the tracking control, is supplied to a terminal 1, and a triangular waveform signal Ss having a constant amplitude and a constant cyclic period, as also shown in Figure 2A, is supplied to a terminal 2. The signals Se and Ss are compared in voltage level with each other by a level comparator 3, and a PWM signal S1 which has a high level h when the voltage level of the signal Se is higher than that of the signal Ss, and a low level 1 when the voltage level of the signal Se is equal to or lower than that of the signal Ss, so as to be formed into a series of pulses each having a width varying in response to variations in the voltage level of the signal Se, as shown in Figure 2B, is derived from the comparator 3. The PWM signal S1 is supplied directly to one of the input terminals of a driving circuit 5, and also to an inverter 4. The PWM signal S1 supplied to the inverter 4 is subjected to level inversion thereat so as to be formed into an inverted PWM signal S2 as shown in Figure 2C, and this signal S2 is supplied to the other of the input terminals of the driving circuit 5.

The driving circuit 5 is operative to supply a driving current to an electromagnetic coil 6 forming an actuating device for driving the optical device, for example, the lens or the mirror, and comprises a pair of complementary transistors 7 and 8 having respective bases connected in common to the input terminal to which the PWM signal S1 is supplied, and another pair of complementary transistors 9 and 10 having respective bases connected in common to the input terminal to which the inverted PWM signal S2 is supplied. The transistors 7 and 8 are connected between a power source +B0 and earth, with respective emitters coupled in common to make a connection point P1, and the transistors 9 and 10 are also connected between the power source +B0 and earth with respective emitters coupled in common to make a connection point P2. The coil 6 is connected between the points P1 and P2.

With this configuration, when the PWM signal S1 has the high level h and the inverted PWM signal S2 has the low level l, the transistors 7 and 10 are made conductive, so that the coil 6 is supplied with a first driving current flowing therethrough from the point P1 to the point P2, and when the PWM signal S1 has the low level l and the inverted PWM signal S2 has the high level h, and the transistors 8 and 9 are made conductive, so that the coil 6 is supplied with a second driving current flowing therethrough from the point P2 to the point P1. Accordingly, the intervals in which the first driving current flows through the coil 6, and the intervals in which the second driving current flows through the coil 6 are varied in response to the variations in the voltage level of the analogue control signal Se.

However, in such a proposed control circuit, the control gain G is in proportion to the ratio of the voltage E0 of the power source +B0 to the amplitude (peak-to-peak value) of the triangular waveform signal Ss, and therefore the control gain G is undesirably varied and exerts a deleterious influence on the current supply to the coil 6 if the voltage E0 of the power source +B0 varies. Accordingly, it is necessary to provide a stabilized power source supplying a constant voltage as the power source +B0. In such a case, since the power source +B0 forms a power supply for the driving circuit 5 which requires large power, a stabilized power source which is able to supply a large power is required, and this makes the circuit construction more difficult. Moreover, the coil 6 is always supplied with the first or second driving current through the driving circuit 5 when the control circuit operates, and consequently there is a large power consumption in the coil 6.

Japanese patent specification JP-B2-56 27001 discloses a control circuit having the features of the pre-characterizing part of claim 1.

According to the present invention there is provided a control circuit operating with a pulse-width modulated signal, the circuit comprising:

biasing circuit means connected to a power supply and an input terminal for providing an analogue control signal supplied to said input terminal with a first DC voltage level;

voltage generating means connected to said power supply for producing a second DC voltage level higher than the first DC voltage level and a third DC voltage level lower than the first DC voltage level by dividing the power supply voltage;

reference voltage producing means for generating a reference voltage signal having either a triangular or a saw-toothed waveform;

first level comparing means for comparing the voltage level of the analogue control signal provided with the first DC voltage level with the voltage level of the reference voltage signal superimposed on the second DC voltage level and for producing a first pulse-width modulated control signal resulting from the level comparison carried out therein;

second level comparing means for comparing the voltage level of the reference voltage signal superimposed on the third DC voltage level with the voltage level of the analogue control signal provided with the first DC voltage level and for producing a second pulse-width modulated control signal resulting from the level comparison carried out therein; and

driving circuit means including an electromagnetic coil, first and second switching elements connected to respective ends of said electromagnetic coil so as to be supplied with the first pulse-width modulated control signal for driving said electromagnetic coil, and third and fourth switching elements also connected to respective ends of said electromagnetic coil so as to be supplied with the second pulse-width control signal for driving the electromagnetic coil;

characterized in that:

said biasing circuit means is so arranged that said first DC voltage level varies in proportion to variations in a power supply voltage from said power supply;

said voltage generating means is so arranged that each of said second and third DC voltage levels varies in proportion to variations in the power supply voltage; and

said reference voltage producing means is so arranged that said reference voltage signal has an amplitude varying in proportion to variations in the power supply voltage.

The invention will now be described by way of example with reference to the accompanying drawings, in which:

Figure 1 is a schematic circuit diagram showing a previously proposed control circuit;

Figures 2A to 2C are waveform diagrams for explaining the operation of the control circuit of Figure 1;

Figure 3 is a schematic circuit diagram showing an embodiment of control circuit according to the present invention; and

Figures 4A to 4D are waveform diagrams for explaining the operation of the embodiment of Figure 3.

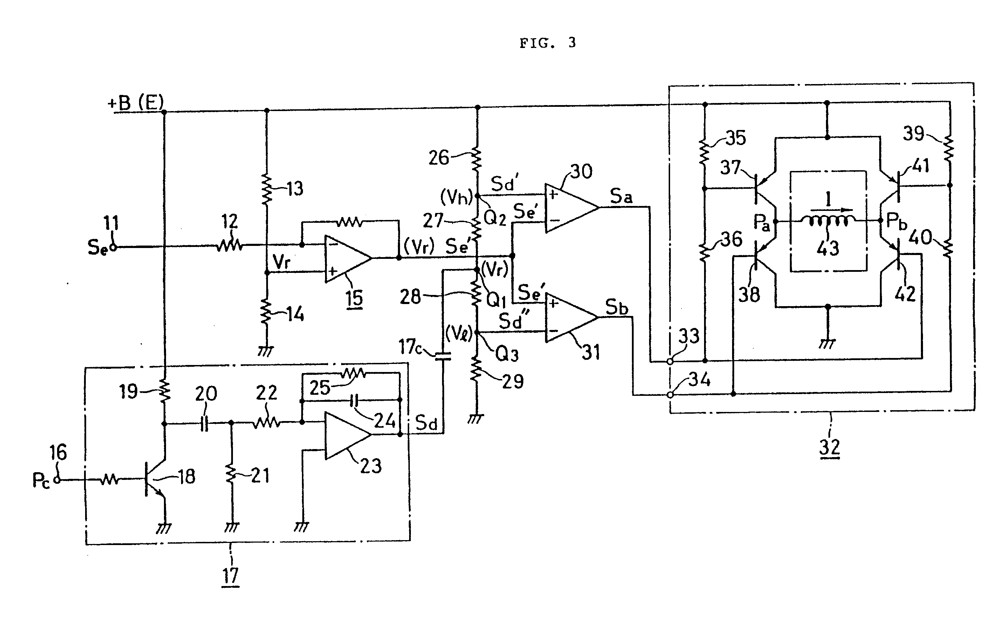

Figure 3 shows the embodiment of control circuit operating with a PWM signal, in which, for example, the above analogue control signal Se is supplied to a terminal 11. The signal Se is supplied through a resistor 12 to a biasing circuit 15 to which a biasing voltage level Vr obtained by dividing a power supply voltage E of a power source +B is applied, and at the output terminal of the biasing circuit 15, a modified analogue control signal Se' which corresponds to the signal Se superimposed on the biasing voltage level Vr is obtained.

A clock pulse signal Pc having a constant cyclic period and a constant pulse-width of each pulse therein is supplied through a terminal 16 to a charging and discharging circuit 17 employing a Miller integrator. The charging and discharging circuit 17 has a switching transistor 18 which has a base supplied with the clock pulse signal Pc, and is turned on and off selectively in response thereto. An emitter of the switching transistor 18 is earthed, and a collector thereof is connected to the power source +B through a resistor 19. A series connection of a capacitor 20 and a resistor 21 is connected between the collector of the switching transistor 18 and earth, and the connection point between the capacitor 20 and the resistor 21 is connected through a resistor 22 to one input terminal of an operational amplifier 23. The other of the input terminals of the operational amplifier 23 is earthed, and a parallel connection of a capacitor 24 and a resistor 25 is connected between an output terminal and the first-mentioned input terminal of the operational amplifier 23, so that the Miller integrator is formed.

In the charging and discharging circuit 17 so formed, the switching transistor 18 is made conductive for a constant duration cyclically at fixed periods by the clock pulse signal Pc, and a rectangular pulse voltage corresponding to the power supply voltage E is obtained cyclically at fixed periods at the collector of the switching transistor 18, whenever it is made non-conductive. In accordance with this rectangular pulse voltage obtained at the collector of the switching transistor 18, charging and discharging are substantially carried out alternately in the Miller integrator including the operational amplifier 23 provided with the parallel connection of the capacitor 24 and the resistor 25, and as a result of this, a triangular waveform voltage signal Sd having a cyclic period corresponding to the cyclic period of the clock pulse signal Pc and an amplitude (peak-to-peak value) proportional to the power supply voltage E is generated at the output terminal of the operational amplifier 23, namely, the output terminal of the charging and discharging circuit 17. That is, the charging and discharging circuit 17 produces the triangular waveform voltage signal Sd which has the amplitude varying in response to variations in the power supply voltage E, when the power supply voltage E is varied.

A voltage divider comprising a series connection of resistors 26, 27, 28 and 29 is connected between the power source +B and earth. This voltage divider is so arranged as to produce a DC voltage level Vr which coincides with the biasing voltage level Vr applied to the biasing circuit 15 at a connection point Q1 between the resistors 27 and 28, a DC voltage level Vh which is higher by a predetermined value corresponding to a half of the amplitude of the triangular waveform voltage signal Sd than the DC voltage level Vr at a connection point Q3 between the resistors 28 and 29. With such an arrangement, the difference between the DC voltage levels Vh and Vl (Vh - Vl) is set to be coincident with the amplitude of the triangular waveform voltage signal Sd.

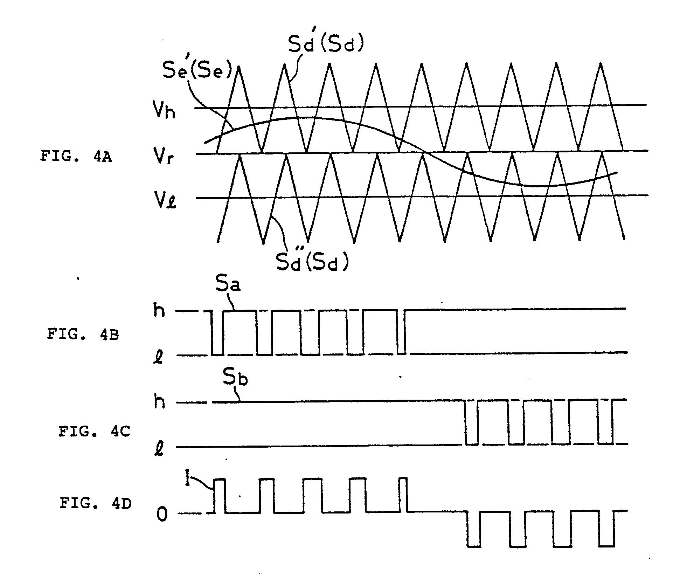

The output terminal of the charging and discharging circuit 17 is connected through a capacitor 17c to the connection point Q1 of the voltage divider, so that the triangular waveform voltage signal Sd is supplied to the connection point Q1. Accordingly, a modified triangular waveform voltage signal Sd' which corresponds to the triangular waveform voltage signal Sd superimposed on the DC voltage level Vh, as shown in Figure 4A, is obtained at the connection point Q2, and another modified triangular waveform voltage signal Sd" which corresponds to the triangular waveform voltage signal Sd superimposed on the DC voltage level Vl, as also shown in Figure 4A, is obtained at the connection point Q3. In such a situation, the bottom level of the modified triangular waveform voltage signal Sd' and the top level of the modified triangular waveform voltage signal Sd" are coincident with the DC voltage level Vr. Although the DC voltage levels Vr, Vh and Vl vary respectively so that the difference between the DC voltage levels Vh and Vr (Vh - Vr) and the difference between the DC voltage levels Vr and Vl (Vr - Vl) are varied when the power supply voltage E varies, the amplitude of the triangular waveform voltage signal Sd also varies in response to the variations in the power supply voltage E, and consequently the relationship between the modified triangular waveform voltage signals Sd' and Sd" and the DC voltage level Vr as shown in Figure 4A and described above is maintained notwithstanding the variations in the power supply voltage E.

The modified triangular waveform voltage signal Sd' obtained at the connection point Q2 and the modified analogue control signal Se' obtained at the output terminal of the biasing circuit 15 are supplied to a level comparator 30 to be compared in voltage level with each other therein, and a PWM signal Sa which has the high level h when the voltage level of the modified triangular waveform voltage signal Sd' is higher than that of the modified analogue control signal Se', and the low level l when the voltage level of the modified triangular waveform voltage signal Sd' is equal to or lower than that of the modified analogue control signal Se', so as to be formed into a signal containing pulses each having a width varying in response to variations in the voltage level of the modified analogue control signal Se', as shown in Figure 4B, is derived from the level comparator 30. Moreover, the modified analogue control signal Se' and the modified triangular waveform voltage signal Sd" obtained at the connection point Q3 are supplied to a level comparing circuit 31 to be compared in voltage level with each other therein, and a PWM signal Sb which is given the high level h when the voltage level of the modified analogue control signal Se' is higher than that of the modified triangular waveform voltage signal Sd", and the low level l when the voltage level of the modified analogue control signal Se' is equal to or lower than that of the modified triangular voltage signal Sd", so as to be formed into a signal containing pulses each having a width varying in response to variations in the voltage level of the modified analogue control signal Se', as shown in Figure 4C, is derived from the level comparator 31.

The PWM signals Sa and Sb thus obtained are supplied to respective input terminals 33 and 34 of a driving circuit 32. The driving circuit 32 comprises a pair of transistors 37 and 38 having respective collector-emitter paths coupled in series through a connection point Pa, and connected between the power source +B and earth, and another pair of transistors 41 and 42 having respective collector-emitter paths coupled in series through a connection point Pb and connected between the power source +B and earth in parallel with the collector-emitter paths of the transistors 37 and 38 coupled in series. Between the connection points Pa and Pb, an electromagnetic coil 43 for driving a unit to be driven, for example, an optical device such as the lens or mirror as aforementioned, is connected. Further, bases of the transistors 37 and 41 are connected to the power source +B through resistors 35 and 39, respectively.

With such an arrangement, the PWM signal Sa from the input terminal 33 is supplied to the base of the transistor 37 through a resistor 36 and to the base of the transistor 42 directly. Similarly, the PWM signal Sb from the input terminal 34 is supplied to the base of the transistor 41 through a resistor 40 and to the base of the transistor 38 directly.

In the driving circuit 32 thus formed, the transistors 37 and 42 are made non-conductive when the PWM signal Sa has the high level h and made conductive when the PWM signal Sa has the low level l, and similarly the transistors 41 and 38 are made non-conductive when the PWM signal Sb has the high level h, and are made conductive when the PWM signal Sb has the low level l. As understood clearly from Figures 48 and 4C, when the PWM signal Sa has the low level l, the PWM signal Sb has the high level h, and when the PWM signal Sb has the low level l, the PWM signal Sa has the high level h. Accordingly, when the PWM signal Sa has the low level l, only the transistors 37 and 42 are made conductive, so that the coil 43 is supplied with a driving current I flowing therethrough in the direction from the point Pa to the point Pb, as indicated with an arrow in Figure 3, and when the PWM signal Sb has the low level l, only the transistors 41 and 38 are made conductive, so that the coil 43 is supplied with the driving current I flowing therethrough in the direction from the point Pb to the point Pa opposite to the direction indicated with the arrow in Figure 3. On the contrary, when both the PWM signals Sa and Sb have the high level h, each of the transistors 37, 38, 41 and 42 is made non-conductive, and therefore the coil 43 is not supplied with any driving current. In such a manner, the current supply to the coil 43 by the driving circuit 32 is controlled in accordance with the PWM signals Sa and Sb, so that the driving current I flows intermittently through the coil 43, as shown in Figure 4D, and each duration in which the driving current I flows continuously through the coil 43 and the direction of the driving current I flowing through the coil 43 are varied in response to the voltage level of the analogue control signal 5e.

As described above, since the coil 43 is supplied intermittently with the driving current I, the power consumption of the coil 43 is effectively reduced, and since the amplitude of each of the modified triangular waveform voltage signals Sd' and Sd" is varied in response to the variations in the power supply voltage £, the ratio of the power supply voltage E to the amplitude of each of the modified triangular waveform voltage signals Sd' and Sd" is kept almost constant, so that the control gain for the driving circuit 32 is maintained to be substantially constant notwithstanding the variations in the power supply voltage E.

Incidentally, although the triangular waveform voltage signal Sd is obtained from the charging and discharging circuit 17 to serve as a reference voltage signal used for converting the analogue control signal Se into the PWM signals Sa and Sb in the embodiment described above, it is possible to have such a modification that a saw-toothed waveform voltage signal is employed, instead of the triangular waveform voltage signal Sd, to serve as the reference voltage signal used for converting the analogue control signal Se into the PWM signals Sa and Sb.

Embodiments of control circuit according to the present invention are capable of controlling, with improved driving efficiency, various movable devices requiring relatively large power and are therefore suitable not only for the optical device such as the lens or mirror of reproducing apparatus for a video disc system or digital audio disc system, but also for any other actuator, for example, a solenoid as employed in various electronic apparatuses.

## Claims

1. A control circuit operating with a pulse-width modulated signal, the circuit comprising:
   biasing circuit means (15) connected to a power supply and an input terminal for providing an analogue control signal supplied to said input terminal with a first DC voltage level;
   voltage generating means (26, 27, 28, 29) connected to said power supply for producing a second DC voltage level higher than the first DC voltage level and a third DC voltage level lower than the first DC voltage level by dividing the power supply voltage;
   reference voltage producing means (17) for generating a reference voltage signal having either a triangular or a saw-toothed waveform;
   first level comparing means (30) for comparing the voltage level of the analogue control signal provided with the first DC voltage level with the voltage level of the reference voltage signal superimposed on the second DC voltage level and for producing a first pulse-width modulated control signal resulting from the level comparison carried out therein;

second level comparing means (31) for comparing the voltage level of the reference voltage signal superimposed on the third DC voltage level with the voltage level of the analogue control signal provided with the first DC voltage level and for producing a second pulse-width modulated control signal resulting from the level comparison carried out therein; and

driving circuit means (32) including an electromagnetic coil (43), first and second switching elements (37, 42) connected to respective ends of said electromagnetic coil (43) so as to be supplied with the first pulse-width modulated control signal for driving said electromagnetic coil (43), and third and fourth switching elements (38, 41) also connected to respective ends of said electromagnetic coil (43) so as to be supplied with the second pulse-width control signal for driving the electromagnetic coil (43);

characterized in that:

said biasing circuit means (15) is so arranged that said first DC voltage level varies in proportion to variations in a power supply voltage from said power supply;

said voltage generating means (26, 27, 28, 29) is so arranged that each of said second and third DC voltage levels varies in proportion to variations in the power supply voltage; and

said reference voltage producing means (17) is so arranged that said reference voltage signal has an amplitude varying in proportion to variations in the power supply voltage.

2. A circuit according to claim 1 wherein said voltage generating means (26, 27, 28, 29) comprises first, second, third and fourth resistors (26, 27, 28, 29) connected in series to said power supply with a first connecting point which is provided between said first and second resistors (26, 27) and at which the second DC voltage level is obtained, a second connecting point which is provided between said third and fourth resistors (28, 29) and at which the third DC voltage level is obtained, and a third connecting point (27, 28) which is provided between said second and third resistors and to which an output terminal of said reference voltage producing means (17) is coupled.

3. A circuit according to claim 1 wherein said reference voltage producing means (17) comprises a charging and discharging circuit (17) employing a Miller integrator and including a switching transistor (18) which is turned on and off alternately by a predetermined clock pulse signal supplied thereto.

4. A circuit according to claim 2 wherein said first level comparing means (30) has a pair of input terminals coupled with said first connecting point of said voltage generating means (26, 27, 28, 29) and an output terminal of said biasing circuit means (15), respectively, and said second level comparing means (31) has a pair of input terminals coupled with the output terminal of said biasing circuit means (15) and said second connecting point of said voltage generating means (26, 27, 28, 29), respectively.

**Revendications**

1. Circuit de contrôle fonctionnant avec un signal modulé en impulsions de largeurs variables comprenant :

un moyen de circuit de polarisation (15) connecté à une alimentation et à une borne d'entrée, pour fournir un signal de contrôle analogique appliqué à la borne d'entrée selon un premier niveau de tension continue ;

un moyen de génération de tension (26, 27, 28, 29) connecté à la l'alimentation pour produire un second niveau de tension continue supérieur au premier niveau de tension continue et un troisième niveau de tension continue inférieur au premier niveau de tension continue, par une division de la tension d'alimentation ;

un moyen de production d'une tension de référence (17) pour générer une signal de tension de référence ayant une forme d'onde soit triangulaire soit en forme de dents de scie ;

un premier moyen de comparaison de niveaux (30) pour comparer le niveau de tension du signal de contrôle analogique délivré avec le premier niveau de tension continue, avec le niveau de tension du signal de tension de référence superposé au second niveau de tension continue, et pour produire un premier signal de contrôle modulé en impulsions de largeurs variables résultant de la comparaison de niveaux effectuée dans celui-ci ;

un second moyen de comparaison de niveaux (31) pour comparer le niveau de tension du signal de tension de référence superposé au troisième niveau de tension continue, avec le niveau de tension du signal de contrôle analogique délivré avec le premier niveau de tension continue, et pour produire un second signal de contrôle modulé en impulsions de largeurs variables résultant de la comparaison de niveaux effectuée dans celui-ci ; et

un moyen de circuit excitation (32) incluant une bobine électromagnétique (43), des premier et second éléments de commutation (37, 42) connectés aux extrémités respectives de la bobine électromagnétique (43) de façon à ce qu'il lui soit appliqué le premier signal de contrôle modulé en impulsions de largeurs variables afin d'exciter la bobine électromagnétique (43), et des troisième et quatrième éléments de commutation (38, 41) connectés également aux extrémités respectives de la bobine électromagnétique (43) de façon à ce qu'il lui soit appliqué le second signal de contrôle en impulsions de largeurs variables afin d'exciter la bobine électromagnétique (43), caractérisé en ce que :

le moyen de circuit de polarisation (15) est agencé de sorte que le premier niveau de tension continue varie proportionnellement aux variations d'une tension d'alimentation provenant de l'alimentation ;

le moyen de génération de tension (26, 27, 28, 29) est agencé de sorte que chacun des second et troisième niveaux de tension continue varie proportionnellement aux variations de la tension d'alimentation ; et en ce que

le moyen pour produire une tension de référence (17) est agencé de sorte que le signal de tension de référence ait une amplitude variant proportionnellement aux variations de la tension d'alimentation.

2. Circuit selon la revendication 1, dans lequel le moyen de génération de tension (26, 27, 28, 29) comprend des première, seconde, troisième et quatrième résistances (26, 27, 28, 29) connectées en série à l'alimentation, avec un premier point de connexion qui est prévu entre les première et seconde résistances (26, 27) et au niveau duquel le second niveau de tension continue est obtenu, un second point de connexion qui est prévu entre les troisième et quatrième résistances (28, 29) et au niveau duquel le troisième niveau de tension continue est obtenu, et un troisième point de connexion (27, 28) qui est prévu entre les seconde et troisième résistances et auquel est relié une borne de sortie du moyen de production d'une tension de référence (17).

3. Circuit selon la revendication 1, dans lequel le moyen de production d'une tension de référence (17) comprend un circuit de charge et de décharge (17) employant un intégrateur Miller et comprenant un transistor de commutation (18) qui est rendu passant et bloqué alternativement par un signal d'impulsion d'horloge appliqué à celui-ci.

4. Circuit selon la revendication 2, dans lequel le premier moyen de comparaison de niveaux (30) présente une paire de bornes d'entrée couplées respectivement au premier point de connexion du moyen de génération de tension (26, 27, 28, 29) et à une borne de sortie du moyen de circuit de polarisation (15), et le second moyen de comparaison de niveaux (31) comprend une paire de bornes de sortie couplées respectivement à la borne de sortie du moyen de circuit de polarisation (15) et au second point de connexion du moyen de génération de tension (26, 27, 28, 29).

**Ansprüche**

1. Mit einem pulsbreitenmodulierten Signal arbeitende Steuerschaltung
mit einer mit einer Stromversorgungseinrichtung und einem Eingang verbundene Vorspannungs-Schaltung (15), die ein dem Eingang zugeführten Steuersignals mit einem ersten Gleichspannungspegel versieht,
mit einer mit der Stromversorgungseinrichung verbundenen Spannungserzeugereinrichtung (26, 27, 28, 29) zur Erzeugung eines zweiten und eines dritten Gleichspannungspegels durch Teilen der Spannung der Stromversorgungseinrichtung, wobei der zweite Gleichspannungspegel größer ist als der erste Gleichspannungspegel und der dritte Gleichspannungspegel kleiner ist als der erste Gleichspannungspegel,
mit einer Einrichtung (17) zur Erzeugung eines Referenzspannungssignals mit entweder dreieckförmigem oder sagezahnförmigem Verlauf,
mit einer ersten Pegelvergleichereinrichtung (30) zum Vergleichen des Spannungspegels des mit dem ersten Gleichspannungspegel versehenen analogen Steuersignals mit dem Spannungspegel des dem zweiten Gleichspannungspegel überlagerten Referenzspannungssignals und zur Erzeugung eines ersten pulsbreitenmodulierten Steuersignals als Ergebnis des Pegelvergleichs,
mit einer zweiten Pegelvergleichereinrichtung (31) zum Vergleichen des dem dritten Gleichspannungspegel überlagerten Referenzspannungssignals mit dem Spannungspegel des mit dem ersten Gleichspannungspegel versehenen analogen Steuersignals und zur Erzeugung eines zweiten pulsbreitenmodulierten Signal als Ergebnis des durchgeführten Pegelvergleichs,

sowie mit einer Antriebsschaltung (32) mit einer Elektromagnet-Spule (43), mit ersten und zweiten Schaltelementen (37, 42), die mit entsprechenden Enden der Elektromagnet-Spule (43) so verbunden sind, daß sie mit dem ersten pulsbreitenmodulierten Steuersignal zur Erregung der Elektromagt-Spule (43) beaufschlagt werden, sowie mit dritten und vierten Schaltelementen (38, 41) die ebenfalls mit entsprechenden Enden der Elektromagnet-Spule (43) so verbunden sind, daß sie mit dem zweiten Pulsbreitenmodulierten Steuersignal zur Erregung der Elektromagnet-Spule (43) beaufschlagt werden,

**dadurch gekennzeichnet,**

daß die Vorspannungs-Schaltung (15) so ausgebildet ist, daß der erste Gleichspannungspegel sich proportional zu Änderungen der von der Stromversorgungseinrichtung kommenden Versorgungsspannung ändert,

daß die Spannungserzeugereinrichtung (26, 27, 28, 29) so ausgebildet ist, daß sowohl der zweite als der dritte Gleichspannungspegel sich proportional zu Änderungen der Versorgungsspannung ändern,

und daß die Einrichtung (17) zur Erzeugung der Referenzspannung so ausgebildet ist, daß die Amplitude des Referenzspannungssignals sich proportional zu Rnderungen der Versorgungsspannung ändert.

2. Schaltung nach Anspruch 1, in der die Spannungserzeugereinrichtung (26, 27, 28, 29) einen ersten, einen zweiten, einen dritten und einen vierten widerstand (26, 27, 28, 29) umfaßt, die mit der Stromversorgungseinrichtung in Reihe geschaltet sind, ferner einen ersten Verbindungspunkt zwischen dem ersten und zweiten widerstand (26, 27), an dem der zweite Gleichspannungspegel gewonnen wird, ferner einen zweiten Verbindungspunkt zwischen dem dritten und vierten widerstand (28, 29), an dem der dritte Gleichspannungspegel gewonnen wird, und einen dritten Verbindungspunkt zwischen dem zweiten und dritten widerstand (27, 28), der mit dem Ausgang der Einrichtung (17) zur Erzeugung der Referenzspannung verbunden ist.

3. Schaltung nach Anspruch 1, in der die Einrichtung (17) zur Erzeugung der Referenzspannung eine Lade- und Entladeschaltung (17) mit einem Miller-Integrator und einem Schalttransistor (18) umfaßt , der durch ein ihm zugeführtes vorbestimmtes Takt impulssignal abwechselnd ein- und ausschaltbar ist.

4. Schaltung nach Anspruch 2, in der die erste Pegelvergleichereinrichtung (30) zwei Eingänge besitzt, die mit dem ersten Verbindungspunkt der Spannungserzeugereinrichtung (26, 27, 28, 29) bzw. mit der Vorspannungs-Schaltung (15) verbunden sind, und in der die zweite Pegelvergleichereinrichtung (31) zwei Eingänge besitzt, die mit dem Ausgang der Vorspannungs-Schaltung (15) bzw. mit dem zweiten Verbindungspunkt der Spannungserzeugereinrichtung (26, 27, 28, 29) verbunden sind.

FIG. 1

+B₀ (E₀)

FIG. 2A

FIG. 2B

FIG. 2C

FIG. 3

EP 0 183 849 B1

FIG. 4A

FIG. 4B

FIG. 4C

FIG. 4D